# EUROPEAN PATENT SPECIFICATION

(11) **EP 1 788 790 B1**
(45) Date of publication and mention of the grant of the patent: **11.06.2008**
(21) Application number: 05110947.8
(22) Date of filing: 18.11.2005
(51) Int. Cl.: H04M 1/725, G06F 3/033

(54) **Keyboard for mobile communication device**
Tastatur für mobiles Kommunikationsgerät
Clavier pour un dispositif mobile de communication

(43) Date of publication of application: 23.05.2007
(73) Proprietor: Research In Motion Limited, Waterloo, Ontario N2L 3W8 (CA)
(72) Inventor: Idzik, Jacek, Kenilworth, Ontario N0G 2E0 (CA); Lowles, Robert, Waterloo, Ontario N2T 2J5 (CA)
(74) Representative: Rickard, David John

(56) References cited:
- FR-A- 2 833 092
- GB-A- 2 406 944
- US-A1- 2003 193 479
- US-B1- 6 611 252

## Description

The present invention relates generally to mobile communication devices. More particularly, the present invention relates to a keyboard for use with a mobile communication device.

The use of mobile communication devices is growing steadily as technology improves. Many individuals now own and use mobile communication devices on a daily basis. These mobile communication devices are typically easy to use and portable. However, there is a push to develop lighter mobile communication devices so that users are not weighed down when carrying their device. This is especially important when a user attaches the mobile communication device to their belt, or puts it in their pocket, or purse.

In some prior art devices, the weight of the keyboard/keypad is a large percentage of the overall weight of the device due to the many switches and parts which form the keyboard/keypad. These switches and parts, also increase the overall thickness of the mobile communication device which detracts from its portability. Furthermore, the cost to manufacture and implement the set of electrical/mechanical switches and parts is quite expensive and complicated.

The long term reliability of mechanical switches in the keyboard/keypad, is quite problematic as the switches are not dependable and generally require constant repair. Moreover, since keyboards/keypads in mobile communication devices are generally not sealed, dirt, dust, liquids, moisture and ESD (electro-static discharge) may enter the mobile communication device which causes the switches to provide intermittent input of data and commands.

GB2406944 discloses a battery operated handset having a keyboard comprising a plurality of manually operable keys. The keyboard has a light source and a set of light detectors associated with the keys. When a key is depressed by a finger of a user, the key is moved into a light path of the light source to thereby deflect the light onto a light detector associated with that key. Deflection of the light path onto a light detector associated with a key is interpreted as a user selection of that key.

US2003/193479 discloses an input device including a source of optical sensor light illuminating an input zone with sensor light. The source of optical sensor light may be ambient light surrounding an operator or a light emitting device adapted to emit light in a direction toward the operator's fingers. The sensor light reflects off the objects in the input zone in a direction generally toward an input device. The data input device also includes an optical detector arranged to receive the reflected sensor light as a reflected light pattern representing the position of the operator's fingers within the input zone. The optical detector converts the reflected light pattern to an electrical signal representing the particular character data desired to be entered by the operator.

FR2833092 discloses the use of light sources such as light emitting diodes (LED's), combined with a standard optical sensor such as a rapid photodiode or phototransistor to detect positions designated by a user by means of a device similar to a pencil or pen. It is particularly applicable to small-size portable devices for which an alphanumerical keyboard or a two-dimensional position defining device is required, such as portable telephone.

It is, therefore, desirable to provide a novel keyboard/keypad for a mobile communication device.

Preferably the present invention obviates or mitigates at least one disadvantage of previous keyboards/keypads for mobile communication devices.

### GENERAL

In a first aspect, the present invention preferably provides a mobile communication device having a keyboard with a set of keys representing alpha-numeric characters, the keyboard comprising a light source, located within the mobile communication device; for providing a light; a set of sensors, associated with the keys, for sensing an amount of the light in a vicinity of each of the set of sensors, to determine which of the set of keys has been selected; and a transparent flat cover, overlying the set of sensors, displaying the set of alpha-numeric characters, for associating the set of alphanumeric characters with the set of sensors.

In a further embodiment, there is preferably provided a keyboard for a mobile communication device comprising a light source for providing a light; a sheet having a set of keys printed thereon; a set of sensors, representing keys of the keyboard; and at least one light pipe, for housing the set of sensors and for receiving and transmitting the light; said sheet overlying said set of sensors and said at least one light pipe; wherein the set of sensors sense an amount of the light to determine which of the keys has been selected.

In further aspect, the present invention preferably provides a method of providing a keyboard for a mobile communication device transmitting a light through a light pipe toward a set of sensors, each sensor associated with a key of said keyboard, the light pipe housing said set of sensors and being overlaid with a sheet having a set of keys printed thereon; determining a key selection by comparing a measured amount of light surrounding each of the set of sensors with a threshold level; transmitting a signal when one of the sensors has determined that the measured amount of light bypasses the threshold value; and storing the key associated with the one of the sensor in memory.

The invention preferably replaces the standard set of mechanical domes, dome overlays, and keys with a single sheet of transparent material and photosensors which pick up the proximity of a finger reflecting light beamed from the device back to the device where a set of sensors measure the amount of light. The electrical nature of the invention allows a thinner keyboard configuration, more reliable operation and closes openings that would otherwise allow dirt, moisture or ESD to enter the handheld. The existing light pipe used to illuminate the keys can be used to also pipe the light, preferably infra-red, at the same time thus saving parts and the electrical mature of the infrared keypad allows a much simpler light pipe design.

A piezo-transducer may also be added to the underside of the keyboard to provide a tactile response to the user when they press a key.

Other aspects and features of the present invention will become apparent to those ordinarily skilled in the art upon review of the following description of specific embodiments of the invention in conjunction with the accompanying figures.

### BRIEF DESCRIPTION OFTHE DRAWINGS

Embodiments of the present invention will now be described, by way of example only, with reference to the attached Figures, wherein:
Fig. 1a is a schematic diagram of a prior art mobile communication device;
Fig. 1b is a schematic diagram of a first embodiment of a keyboard installed in a mobile communication device;
Fig. 2 is a schematic diagram of a portion of a keyboard;
Fig. 3 is a schematic diagram of light travelling in the keyboard;
Fig. 4a is a flowchart of a first embodiment of a method of using the keyboard of Figure 2; and
Fig. 4b is a flowchart of a second embodiment of a method of using the keyboard of Figure 2.

### DESCRIPTION OF PREFERRED EMBODIMENTS

Generally, the invention provides a keyboard/keypad for a mobile communication device, or handheld electronic device. As the terms keyboard and keypad are typically interchangeable when discussing a mobile communication device in this application, the term keyboard will be used to describe both a keyboard and/or a keypad in the following description.

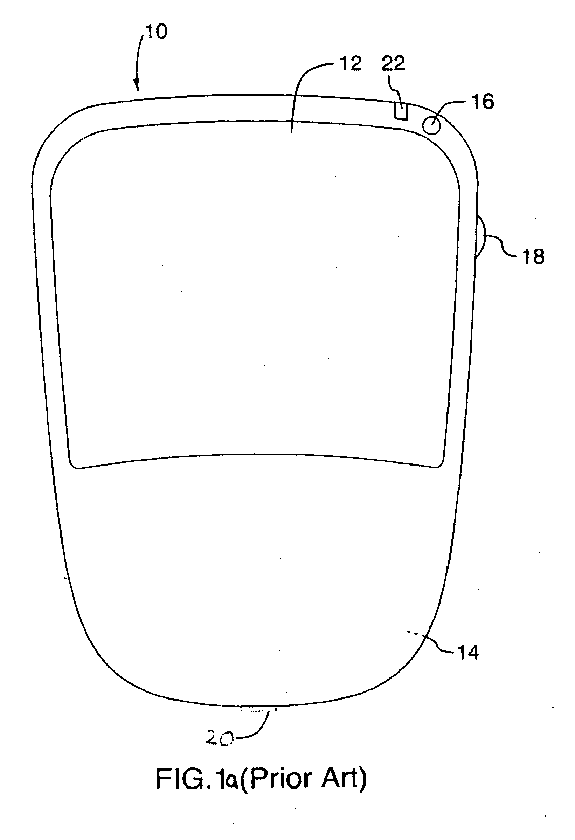

Turning to Figure 1a, a schematic diagram of a prior art mobile communication device is shown. The mobile communication device 10 comprises a display area 12, a keyboard area 14 for receiving a keyboard, a power button 16, a thumbwheel 18 and a communication port 20. The communication device 10 further comprises an indicator lamp 22 which indicates when a new message is received by the device 10. The functionality of these parts will be well known to one skilled in the art. The keyboard area 14 typically includes a plurality of individual keys representing alphanumeric characters.

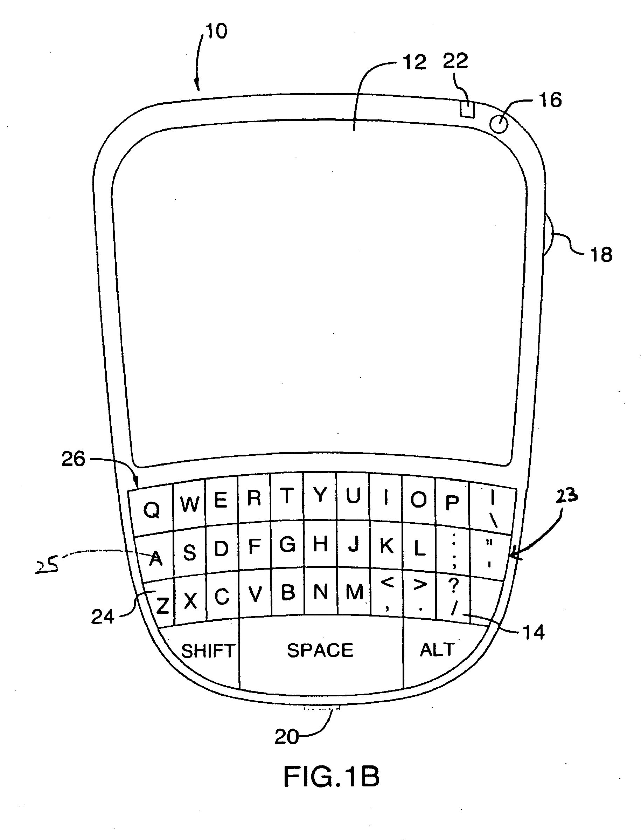

Turning to Figure 1b, a schematic diagram of a mobile communication device, or handheld electronic device, comprising a light source keyboard 23 is shown.

In this embodiment, keyboard lettering 24, outlining alphabetic or alphanumeric keys 25, is provided on a transparent sheet 26 which lies over the keyboard area 14, sealing the keyboard area so that foreign objects, such as dust, dirt or ESD, may not enter the mobile communication device 10. The keyboard lettering 24 is printed on the top surface of the transparent sheet 26 to simulate the presence of a keyboard. In use, a user simply presses, or places their finger over, one of the keys 25 in order to activate the keys as would be required when typing on a keyboard. It will be understood that the design or look of the keyboard is determined by the designer and that various keyboard patterns may be contemplated. The operation of the keyboard is not affected by the different keyboard designs or layouts such as a QWERTY, QWERTZ, AZERTY, QZERTY or other language keyboards.

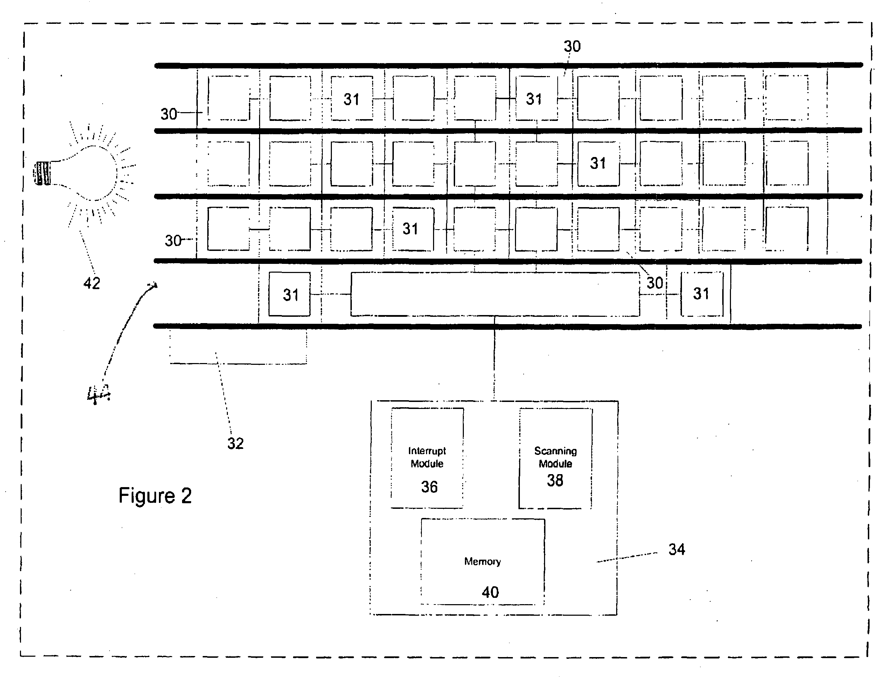

Figure 2 provides a schematic view of a keyboard within the mobile communication. The mobile communication device 10 further comprises a light source 42, preferably an infra-red light source, which provides the necessary light for operation of the keyboard (as will be described in more detail below) along with a set of infra-red sensors 30, each associated with one of the keys 25 of the keyboard and a piezo-transducer 32 which is associated with the set of infra-red sensors 30 to provide a tactile response to the user when they press the key. By having only a single transducer, this assists in decreasing the size and weight of the device and helps the simplicity of the internal set up of the device.

Each of the sensors 30 includes a corresponding filter 31, preferably a bandpass filter, which assists in sensing the light from the light source 42. Each bandpass filter 31 is preferably separate from, but associated and in communication, with one of the set of sensors 30. However, the bandpass filter 31 and the sensor 30 may also be provided as a sensor and bandpass filter combination. In the preferred embodiment, by using a bandpass filter, only selected frequencies of the infra-red light are sensed by the sensors 30 and ambient light does not interfere with the readings of the sensors 30.

Each of the rows of sensors are located in a light pipe 44 which receives the light from the light source 42 and directs the light towards each of the sensors 30 which are preferably connected to, and in communication with, a processor 34 (within the mobile communication device 10) which processes the keys which are being pressed. The processor 34 preferably comprises an interrupt module 36, a scanning module 38 and a memory 40.

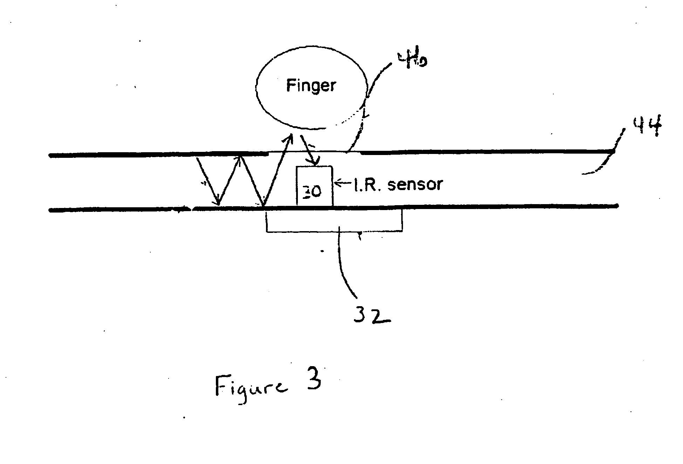

As shown in Figure 3, in operation, infra-red light from the light source 42 is received by and transmitted along the light pipe 44 and is reflected off the light pipe 44 by bouncing off the bottom of the keyboard (cover 26) and the borders of the keys until the light reaches an opening 46 (which represent the keys 25 of the keyboard 23) to deliver the light to the set of sensors 30.

The sensor 30 located underneath each of the openings sense the amount of infra-red light in its immediate vicinity as the ambient light is filtered out by the bandpass filters 31. When there is no finger of object covering the opening, the sensor 30 only senses an expected, or default, value of light and therefore concludes that the key associated with the sensor 30 has not been selected. It will be understood that each of the sensors has a threshold infra-red light value (representing the expected value) but once this threshold is passed (indicating the presence of a finger), the sensor transmits a signal, such as an interrupt signal, to the processor 34.

When a finger is placed over the opening 46, the presence of the finger deflects the infra-red light towards the sensor 30 so that the sensor 30 senses the increase of infra-red light (above the threshold value). Each time a key is pressed, the piezo-transducer 32 provides a tactile response to the user to recognize that a key has been pressed.

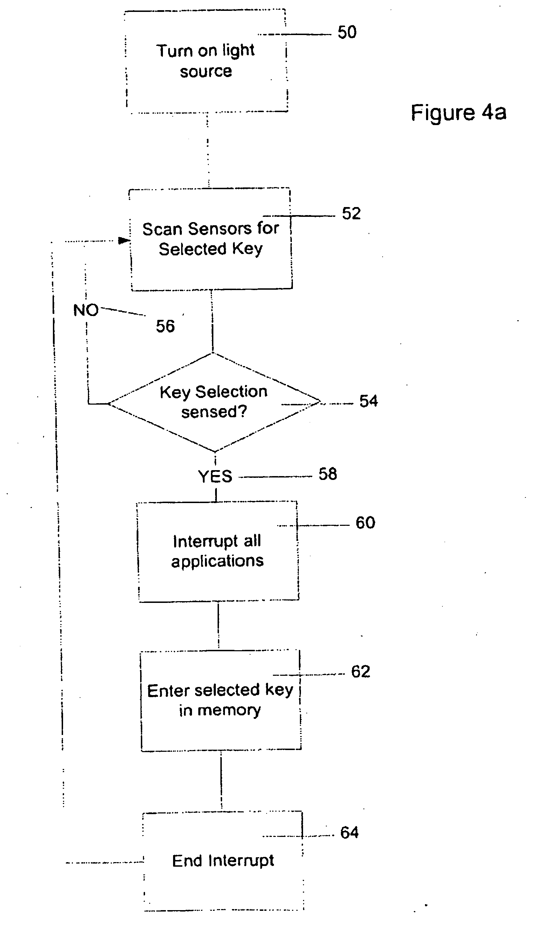

Turning to Figure 4a, a first method of operation of the keyboard is shown. In this embodiment, once the mobile communication device is turned on, the light source 42 turns on and transmits light, preferably infra-red through the light pipe 44 (step 50). It will be understood by one skilled in the art that the infra-red light is modulated from 20 to 40 khz from the source 42 in order to distinguish the infra-red light from ambient light. Simultaneously, the processor 34 proceeds to scan the sensors 30 (via the scanning module 38) to determine if any one of the sensors 30 has sensed the presence of an object, such as a finger, near their associated opening (step 52) represented by a light reading which is past the threshold value. As discussed above, the bandpass filter 31 associated with each of the sensors 30, prevents ambient light (or light which is not at the pre-determined modulated frequency) from passing through so that the sensor 30 obtains a reading of the amount of infra-red light to determine if the associated key has been pressed. Constant checks are performed to determine when a key selection is sensed (step 54). If no key selection has been sensed (step 56), the scanning module 38 continues to scan until it senses that one of the set of sensors 30 has created a signal indicating that it has sensed a change in the amount of infra-red light being sensed thereby bypassing the threshold value (step 58). This signal, which preferably includes an identification as to which key has been selected, is then transmitted to the processor 34. Upon receipt of this signal, the processor 34 proceeds to enter the interrupt table 36 to interrupt all applications (step 60) executing on the processor 34 so that the selected key may be entered into the memory 40 (step 62). After the selected key has been entered into memory 40, the interrupt is ended (step 64) and the applications continue executing while the processor 34 returns to scanning the sensors (step 52) for further key selections. This process is continued until the mobile communication device 10 is turned off.

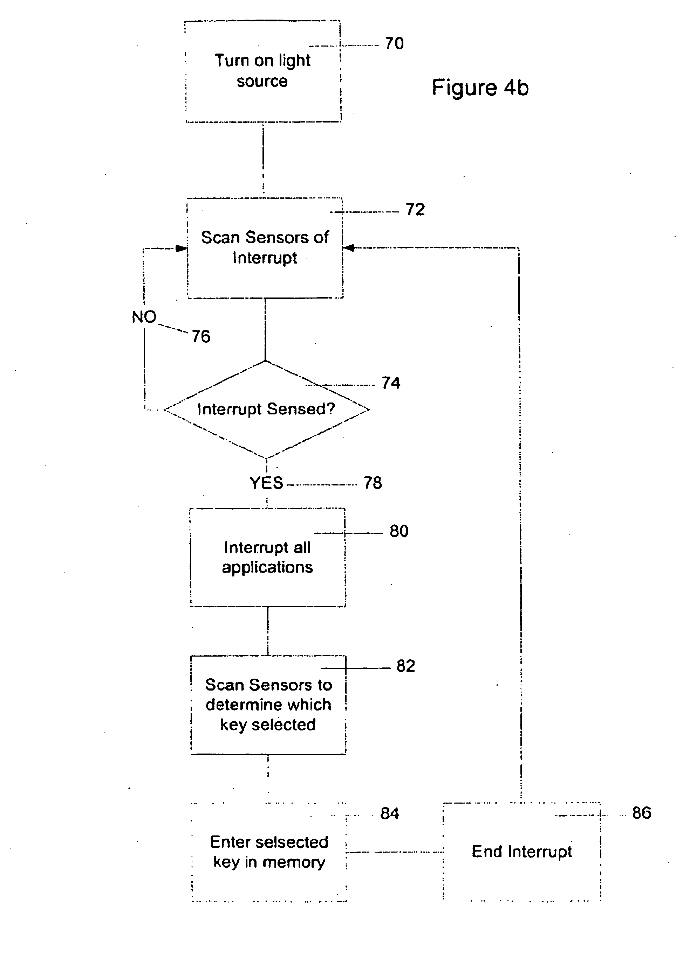

In another embodiment of a method, as shown in Figure 4b, after the mobile communication device 10 is turned on, thereby activating the light source 42 (step 70), the processor 34 scans the set of sensors 30 (via the scanning module 38) for an interrupt signal (step 72). In this method, if a sensor 30 senses a change in the amount of light being sensed (i.e. passes the threshold value), the sensor 30 produces an interrupt signal. The scanning module 38 continues to scan the sensors until the interrupt signal is sensed (step 74). If no interrupt signal is sensed (step 76), the scanning module continues to scan (step 72). However, once an interrupt signal is sensed (step 78), the processor 34 enters the interrupt table 36 to interrupt all the applications currently executing on the processor 34 (step 80). The scanning module 38 then scans each of the sensors 30 to determine which of the sensors produced the interrupt signal (step 82). Once this has been determined, the key associated with the sensor requesting the interrupt is entered into the memory 40 (step 84) and the interrupt table exited (step 86) so that the applications may return to their previous state and continue executing. The processor 34 then returns to scanning the sensors for the next interrupt signal (step 72).

As discussed above, the keyboard preferably includes one piezo-transducer for the set of sensors to provide a tactile response to the user's finger so that the user is provided with a keyboard-like feel when they press one of the keys on the cover. However, it will be understood that two transducers may be provided with one at opposite sides of the mobile communication device. Furthermore, a plurality of transducers, such as one under each of the sensors, is contemplated, however this decision is generally based on the overall size of the device. It is understood that less transducers are preferred as this assists in decreasing the overall weight and size of the device.

In another embodiment, the bandpass filter may be a programmable filter and may also be implemented in software.

In an alternative embodiment, the light source may be a light source which provides visible light such as a back-light, which is used in current mobile communication devices. In order to sense the visible light, the light is modulated to co-operate with the characteristics of the bandpass filters associated with the sensors. This provides an added advantage of saving battery power since there is no need for a separate light source to operate the keyboard.

Alternatively, each row of keys may be set up in its own light pipe rather than having a single light pipe encompassing all of the keys.

The above-described embodiments of the present invention are intended to be examples only. Alterations, modifications and variations may be effected to the particular embodiments by those of skill in the art without departing from the scope of the invention, which is defined solely by the claims appended hereto.

## Claims

1. A keyboard (23) for a handheld electronic device (10) comprising:
a light source (42) for providing light;
a sheet (26) having a set of keys (24) printed thereon;
a set of sensors (30), representing keys of said keyboard; and
at least one light pipe (44), for housing said set of sensors and for receiving and delivering said light to said sensors;
said sheet overlying said set of sensors and said at least one light pipe;
wherein each sensor of said set of sensors senses an amount of said light to determine which of said keys has been selected.

2. The keyboard (23) of claim 1 wherein said light source (42) is arranged to provide an infra-red light or a visible light.

3. The keyboard (23) of claim 2 wherein said light source (42) is arranged to modulate said infra-red light or visible light to a predetermined frequency.

4. The keyboard (23) of claim 3 further comprising:
a set of bandpass filters (31), each associated with one sensor (30) of said set of sensors, for filtering out ambient light from said modulated light being delivered to each sensor of said set of sensors.

5. The keyboard (23) of any one of claims 1 to 4 further comprising:
at least one transducer (32) for providing a tactile response to a user when one of said keys is selected.

6. The keyboard (23) of claim 5 wherein a transducer (32) is placed at opposite sides of said keyboard.

7. The keyboard (23) of claim 5 or claim 6 wherein said transducer is a piezo-electric transducer (32).

8. The keyboard (23) of any one of claims 1 to 7 further comprising:
a processor (34) for storing and processing said selected keys.

9. The keyboard (23) of claim 8 wherein said processor (34) further comprises:
a scanning module (38) for scanning said sensors (30) to determine when a key has been selected; and
memory (40) for storing said selected key.

10. The keyboard (23) of claim 9 further comprising an interrupt table for interrupting applications executing on said processor (34) so that said selected key may be entered into said memory (40).

11. The keyboard (23) of any one of claims 1 to 10 further comprising:
means (26) for identifying said keys within said keyboard.

12. The keyboard (23) of claim 11 wherein said means for identifying said keys is a transparent cover (26) having key lettering on a top surface overlying said set of sensors (30) and mounted on a surface of said handheld electronic device (10).

13. A method of providing a keyboard (23) for a handheld electronic device (10) comprising the steps of:
transmitting a light through a light pipe (44) toward a set of sensors (30), each sensor associated with a key of said keyboard, the light pipe housing said set of sensors and being overlaid with a sheet (26) having a set of keys printed thereon;
determining a key selection by comparing a measured amount of light surrounding each sensor of said set of sensors with a threshold level;
transmitting a signal when one sensor of said set of sensors has determined that said measured amount of light bypasses said threshold value; and
storing said key associated with said one sensor of said set of sensors in memory (40).

14. The method of claim 13 further comprising the step, occurring before the step of determining, of:
modulating said light.

15. The method of claim 14 wherein said step of determining comprises the step of:
filtering said modulated light from ambient light surrounding each of said sensors (30);
measuring said amount of filtered light sensed by each of said sensors; and
comparing said measured value with a threshold value.

16. The method of any one of claims 13 to 15 further comprising, occurring before the step of storing, the step of:
using an interrupt table to interrupt all applications executing on said mobile communication device (10).

17. The method of claim 16 further comprising the step of:
exiting said interrupt table.

18. A handheld electronic device (10) having the keyboard (23) of any one of claims 1 to 12.

## Patentansprüche

1. Tastatur (23) für ein elektronisches Handheld-Gerät (10), umfassend:
eine Lichtquelle (42) zum Bereitstellen von Licht;
eine Folie (26) mit einem darauf gedruckten Satz von Tasten (24);
einen Satz von Sensoren (30), welche die Tasten der Tastatur repräsentieren; und
mindestens einen Lichtleiter (44) zur Unterbringung des Satzes von Sensoren und zum Empfangen und Zuführen des Lichts zu den Sensoren; dabei die Folie den Satz von Sensoren und den mindestens einen Lichtleiter überlagernd;
wobei jeder Sensor aus dem Satz von Sensoren eine Menge des Lichts erfasst, um zu ermitteln, welche der Tasten ausgewählt wurde.

2. Tastatur (23) gemäß Anspruch 1, wobei die Lichtquelle (42) dazu eingerichtet ist, ein Infrarotlicht oder ein sichtbares Licht bereitzustellen.

3. Tastatur (23) gemäß Anspruch 2, wobei die Lichtquelle (42) dazu eingerichtet ist, das Infrarotlicht oder das sichtbare Licht in eine vorgegebene Frequenz zu modulieren.

4. Tastatur (23) gemäß Anspruch 3, des Weiteren umfassend:
einen Satz von Bandpassfiltern (31), von denen jeder einem Sensor (30) aus dem Satz von Sensoren zugeordnet ist, zum Ausfiltern von Umgebungslicht aus dem modulierten Licht, das jedem Sensor des Satzes von Sensoren zugeführt wird.

5. Tastatur (23) gemäß einem der Ansprüche 1 bis 4, des Weiteren umfassend:
mindestens einen Wandler (32) zum Bereitstellen einer fühlbaren Reaktion an einen Benutzer, wenn eine der Tasten ausgewählt wird.

6. Tastatur (23) gemäß Anspruch 5, wobei ein Wandler (32) an den gegenüberliegenden Seiten der Tastatur platziert ist.

7. Tastatur (23) gemäß Anspruch 5 oder Anspruch 6, wobei der Wandler ein piezoelektrischer Wandler (32) ist.

8. Tastatur (23) gemäß einem der Ansprüche 1 bis 7, des Weiteren umfassend:
einen Prozessor (34) zum Speichern und Verarbeiten der ausgewählten Tasten.

9. Tastatur (23) gemäß Anspruch 8, wobei der Prozessor (34) des Weiteren umfasst:
ein Abtastmodul (38) zum Abtasten der Sensoren (30), um zu ermitteln, wann eine Taste ausgewählt wurde; und
Speicher (40) zum Speichern der ausgewählten Taste.

10. Tastatur (23) gemäß Anspruch 9, des Weiteren umfassend eine Unterbrechungstabelle zum Unterbrechen der Anwendungen, die gerade auf dem Prozessor (34) ausgeführt werden, so dass die ausgewählte Taste in den Speicher (40) eingegeben werden kann.

11. Tastatur (23) gemäß einem der Ansprüche 1 bis 10, des Weiteren umfassend: Mittel (26) zum Identifizieren der Tasten innerhalb der Tastatur.

12. Tastatur (23) gemäß Anspruch 11, wobei das Mittel zum Identifizieren der Tasten eine transparente Abdeckung (26) ist, welche auf einer Oberfläche, die den Satz von Sensoren (30) überlagert, eine Tastenbeschriftung hat und auf einer Oberfläche des elektronischen Handheld-Geräts (10) befestigt ist.

13. Verfahren zum Bereitstellen einer Tastatur (23) für ein elektronisches Handheld-Gerät (10), umfassend die folgenden Schritte:
das Übertragen eines Lichts durch einen Lichtleiter (44) zu einem Satz von Sensoren (30), wobei jeder Sensor einer Taste der Tastatur zugeordnet ist, der Lichtleiter den Satz von Sensoren unterbringt und durch eine Folie (26) überlagert ist, auf die ein Satz von Tasten gedruckt ist;
das Ermitteln einer Tastenauswahl durch Vergleichen einer gemessenen Lichtmenge in der Umgebung jedes Sensors aus dem Satz von Sensoren mit einem Schwellenwert;
das Übertragen eines Signals, wenn ein Sensor aus dem Satz von Sensoren ermittelt hat, dass die gemessene Lichtmenge den Schwellenwert übersteigt; und
das Speichern der Taste, die dem einen Sensor aus dem Satz von Sensoren zugeordnet ist, im Speicher (40).

14. Verfahren gemäß Anspruch 13, des Weiteren umfassend den folgenden Schritt, welcher vor dem Schritt des Ermittelns erfolgt:
das Modulieren des Lichts.

15. Verfahren gemäß Anspruch 14, wobei der Schritt des Ermittelns den folgenden Schritt umfasst:
das Ausfiltern des modulierten Lichts aus dem Umgebungslicht, das jeden der Sensoren (30) umgibt;
das Messen der Menge des ausgefilterten Lichts, die durch jeden der Sensoren erfasst wird, und das Vergleichen des gemessenen Werts mit einem Schwellenwert.

16. Verfahren gemäß einem der Ansprüche 13 bis 15, des Weiteren umfassend den folgenden Schritt, welcher vor dem Schritt des Speicherns erfolgt:
das Verwenden einer Unterbrechungstabelle zum Unterbrechen aller Anwendungen, die gerade auf dem mobilen Kommunikationsgerät (10) ausgeführt werden.

17. Verfahren entsprechend Anspruch 16, des Weiteren umfassend den folgenden Schritt:
das Verlassen der Unterbrechungstabelle.

18. Elektronisches Handheld-Gerät (10) mit der Tastatur (23) gemäß einem der Ansprüche 1 bis 12.

## Revendications

1. Clavier (23) pour dispositif électronique de poche (10) comprenant :
une source lumineuse (42) pour fournir de la lumière ;
une feuille (26) sur laquelle un ensemble de touches (24) est imprimé ;
un ensemble de capteurs (30) représentant les touches dudit clavier ; et
au moins un conducteur de lumière (44) pour héberger ledit ensemble de capteurs et pour recevoir et fournir ladite lumière auxdits capteurs;
ladite feuille recouvrant ledit ensemble de capteurs et le(s) dit(s) conducteur(s) de lumière;
dans lequel chaque capteur dudit ensemble de capteurs capte une quantité de ladite lumière pour déterminer laquelle des dites touches a été sélectionnée.

2. Clavier (23) de la revendication 1 dans lequel ladite source lumineuse (42) est agencée pour fournir une lumière infrarouge ou une lumière visible.

3. Clavier (23) de la revendication 2 dans lequel ladite source lumineuse (42) est agencée pour moduler ladite lumière infrarouge ou une lumière visible suivant une fréquence prédéterminée.

4. Clavier (23) de la revendication 3 comprenant en outre :
un ensemble de filtres passe bas (31), associés chacun à un capteur (30) dudit ensemble de capteurs, servant à éliminer par filtrage la lumière ambiante de ladite lumière modulée fournie à chaque capteur du dit ensemble de capteurs.

5. Clavier (23) de l'une quelconque des revendications 1 à 4 comprenant en outre :
au moins un transducteur (32) pour fournir une réponse tactile à un utilisateur quand l'une desdites touches est sélectionnée.

6. Clavier (23) de la revendication 5 dans lequel un transducteur (32) est placé à des côtés opposés dudit clavier.

7. Clavier (23) de la revendication 5 ou 6 dans lequel ledit transducteur est de nature piézo-électrique (32).

8. Clavier (23) de l'une quelconque des revendications 1 à 7 comprenant en outre :
un processeur (34) pour stocker et traiter lesdites touches sélectionnées.

9. Clavier (23) de la revendication 8 dans lequel ledit processeur (34) comprend en outre :
un module de balayage (38) pour balayer lesdits capteurs (30) afin de déterminer quand une clé a été sélectionnée ; et
une mémoire (40) pour stocker ladite touche sélectionnée.

10. Clavier (23) de la revendication 9 comprenant en outre une table d'interruption pour interrompre les applications en cours d'exécution sur ledit processeur (34) de manière que ladite touche sélectionnée puisse être saisie dans ladite mémoire (40).

11. Clavier (23) de l'une quelconque des revendications 1 à 10, comportant en outre un moyen (26) pour identifier lesdites touches au sein dudit clavier.

12. Clavier (23) de la revendication 11 dans lequel ledit moyen d'identification desdites touches est un capot transparent (26) qui possède le lettrage des touches sur une surface supérieure recouvrant ledit ensemble de capteurs (30) et qui est monté sur une surface dudit dispositif électronique de poche (10).

13. Procédé de réalisation de clavier (23) pour un dispositif électronique de poche (10) comprenant les étapes suivantes :
transmettre de la lumière par un conducteur lumineux (44) vers un ensemble de capteurs (30), chaque capteur étant associé à une touche dudit clavier, le conducteur de lumière hébergeant ledit ensemble de capteurs et étant recouvert d'une feuille (26) sur laquelle un ensemble de touches (24) est imprimé;
déterminer une sélection de touches en comparant une quantité de lumière mesurée autour de chaque capteur dudit ensemble de capteurs à un niveau de seuil ;
transmettre un signal quand un capteur dudit ensemble de capteurs a déterminé que ladite quantité de lumière mesurée franchit la valeur de seuil ; et
stocker ladite touche associée audit capteur dudit ensemble de capteurs en mémoire (40).

14. Procédé de la revendication 13 comprenant en outre l'étape, précédant celle de détermination, consistant à :
moduler ladite lumière.

15. Procédé de la revendication 14 dans lequel ladite étape de détermination comprend l'étape consistant à :
filtrer ladite lumière modulée de la lumière ambiante autour de chacun desdits capteurs (30) ;
mesurer ladite quantité de lumière filtrée captée par chacun des dits capteurs ; et
comparer ladite valeur mesurée à une valeur de seuil.

16. Procédé de l'une quelconque des revendications 13 à 15 comprenant en outre l'étape, précédant celle de stockage, consistant à :
utiliser une table d'interruptions pour interrompre toutes les applications en cours d'exécution sur ledit dispositif de communication mobile (10).

17. Procédé de la revendication 16 comportant en outre l'étape consistant à :
quitter ladite table d'interruptions.

18. Dispositif électronique de poche (10) possédant le clavier (23) de l'une quelconque des revendications 1 à 12.
